**Europäisches Patentamt**

**European Patent Office**

**Office européen des brevets**

(11) Veröffentlichungsnummer: **0 039 015**
**A2**

(12) **EUROPÄISCHE PATENTANMELDUNG**

(21) Anmeldenummer: **81102958.6**

(22) Anmeldetag: **16.04.81**

(51) Int. Cl.³: **H 01 L 29/72**
**H 01 L 29/10, H 01 L 29/16**
**H 01 L 21/00**

(30) Priorität: **29.04.80 DE 3016553**

(43) Veröffentlichungstag der Anmeldung:
**04.11.81 Patentblatt 81/44**

(84) Benannte Vertragsstaaten:
**FR GB IT**

(71) Anmelder: **SIEMENS AKTIENGESELLSCHAFT Berlin und München**
**Postfach 22 02 61**
**D-8000 München 22(DE)**

(72) Erfinder: **Werner, Wolfgang, Dr.**
**Lorenzonistrasse 66**
**D-8000 München 90(DE)**

(54) **Planartransistor, insbesondere für I2L-Strukturen.**

(57) Die Erfindung betrifft eine Transistorstruktur, die inesbesondere als Vertikaltransistor für I²L-Logikzellen geeignet ist. Ein wesentliches Merkmal dieser Strucktur ist, daß in der Basiszone dieses Transistors abseits vom Kollektorbereich des Transistors ein höher als die überige Basiszone doterter polykristalliner Bereich vorgesehen ist, der die Basiselektrode trägt. Ein weiteres Merkmal des Transistors ist, daß der polykristalline Teil der Basiszone vom Emitter durch eine Isolierschicht, insbesondere SiO₂ getrennt ist. Die Erfindung befaßt sich weiter mit der Herstellung eines solchen Transistors. Erreicht wird durch die Erfindung gegenüber den herkömmlichen Strukturen eine Reduzierung der Verzögerungszeit des Transistors und damit ein rascheres Ansprechen der mit seiner Hilfe aufgebauten Logik.

FIG 3

Siemens Aktiengesellschaft     Unser Zeichen
Berlin und München     VPA

80 P 1 0 6 0 E

Planartransistor, insbesondere für I$^2$L-Strukturen

Die Erfindung betrifft einen Planartransistor, insbesondere für I$^2$L-Strukturen, bei dem an der Oberfläche eines insbesondere aus monokristallinem Silicium bestehenden Halbleiterplättchens wenigstens eine von der Basiszone vom übrigen Teil des Halbleiterplättchens getrennte Kollektorzone vorgesehen ist, bei dem die Basiszone am Ort der Basiselektrode höher als im Bereich zwischen der Kollektorzone und der Emitterzone dotiert ist und bei dem schließlich die Halbleiteroberfläche wenigstens am Ort der pn-Übergänge mit einer anorganischen Isolierschicht, insbesondere aus SiO$_2$, abgedeckt ist.

Ein solcher Planartransistor ist z.B. in "IEEE Journal of Solid-State Circuits" Vol. SC-12, No. 2 (April 1977) S. 123 - 127 beschrieben. Da solche Transistoren gewöhnlich in digitalen integrierten Halbleiterschaltungen, insbesondere als I$^2$L-Zellen, eingesetzt werden, spielt die durch den Transistor bedingte Verzögerungszeit eine erhebliche Rolle.

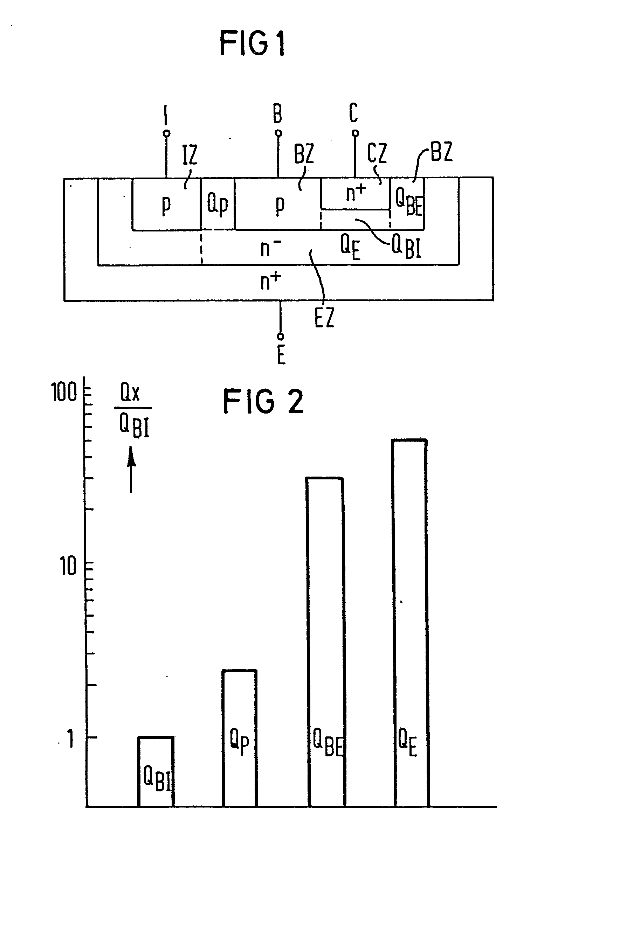

Die minimale Verzögerungszeit $t_{D\ min}$ von $I^2$L-Schaltungen wird nun nahezu ausschließlich durch die Diffusionskapazitäten (d.h. die Speicherkapazitäten ihrer durch Diffusion hergestellten pn-Übergänge) bzw. durch die Speicherung von Minoritätsträgern in den aus Fig. 1 ersichtlichen Bereichen des Transistors eines $I^2$L-Gatters bestimmt. Hiermit befassen sich die Literaturstellen "IEEE Journal of Solid-State Circuits" Vol. SC-12, No. 2 (April 1977), S. 171 - 176, und "IEEE Transactions on Electron Devices" Vol. ED-22, No. 3 (März 1975), S. 145 - 152.

Aufgrund der Darlegungen dieser Literaturstellen läßt sich die minimale Verzögerungszeit $t_{D\ min}$ durch Berechnung der im eingeschalteten Zustand gespeicherten Minoritätsträgerladung gemäß

$$t_{D\ min} = (\sum Q_x)/\ 2I_J$$

abschätzen, wobei $Q_x$ die in den aus Fig. 1 ersichtlichen Bereichen des Transistors der $I^2$L-Zelle gespeicherte Minoritätsträgerladung und $I_J$ der über den Emitter in die Basis injizierte Injektorstrom ist.

Wie aus Fig. 1 ersichtlich ist, bildet sich die Ladung $Q_{BI}$ im Bereich der Basiszone BZ zwischen der Emitterzone EZ und der Kollektorzone CZ des Transistors. Die Ladung $Q_{BE}$ sammelt sich ebenfalls in der Basiszone BZ zwischen Emitterzone EZ und Kollektorzone CZ an. Die Ladung $Q_{BE}$ befindet sich jedoch seitlich der Kollektorzone an der Halbleiteroberfläche und die Ladung $Q_{BI}$ unterhalb der Kollektorzone CZ. Die Ladung $Q_E$ befindet sich in der Emitterzone EZ in deren an die Basiszone BZ angrenzendem Bereich zwischen der Basiszone und der hochdotierten Emitterkontaktierungszone. Die Ladung $Q_P$ schließlich befindet sich im niedrig dotierten Bereich der Emitterzone EZ zwischen der Basiszone BZ und der Injektorzone IZ der $I^2$L-Anordnung.

0039015

Der aus dem Kollektor CZ, der Basis BZ und dem Emitter EZ bestehende Transistor wird also in besonderem Maße von der Ladungsspeicherung und damit von der durch diese bedingte Verzögerung betroffen. Ergänzend ist noch zu bemerken, daß ·I den Injektoranschluß, E den Emitteranschluß, B den Basisanschluß und C den Kollektoranschluß sowie p und n bzw. $n^+$, wie üblich, die Dotierungsart der einzelnen Bereiche des in Fig. 1 im Längsschnitt gezeigten $I^2L$-Transistors bedeuten.

Für die in der oben angegebenen Formel hat man aufgrund der soeben angegebenen gespeicherten Ladungen

$$\sum Q_x = Q_{BI} + Q_P + Q_{BE} + Q_E$$

zusetzen.

Ersichtlich kann die minimale Verzögerungszeit drastisch reduziert werden, wenn man die Minoritätsladungsträgerspeicherung auf den für die Funktion des Transistors unbedingt notwendigen Bereich Bereich, also auf deren zwischen Kollektor und Emitter nach der Tiefe zu angeordneten Bereich, beschränkt. Das Verhältnis der in einem Transistors gemäß Fig. 1 gespeicherten Minoritätsladungsträger $Q_x$ ist in Fig. 2 dargestellt.

Die Aufgabe der vorliegenden Erfindung ist nun darin zu sehen, daß Maßnahmen bezüglich des Aufbaus des Transistors bzw. bei seiner Herstellung ergriffen werden sollen, die erheblich zur Verminderung der gespeicherten Ladungen $Q_x$ beitragen und damit die Schaltgeschwindigkeit des Transistors der $I^2L$-Zelle beträchtlich erhöhen, was zu einer Reduktion der Schaltzeit einer mit solchen Transistoren aufgebauten $I^2L$-Logik und auch anderer solche Transistoren verwendenden digitaler Schaltungen bis in den Subnanobereich hinein führt.

0039015

Die Vermeidung der Minoritätsträgerspeicherung im Emitterbereich, also die Unterdrückung der Ladung $Q_E$ wäre durch Verwendung einer $n^+p\,n^+$-Struktur für den Transistor möglich. Bei der herkömmlichen Technologie werden die Basiszone BZ und die Kollektorzone CZ durch Diffusion oder durch Implantation in einer epitaktisch abgeschiedenen Halbleiterschicht erzeugt, was zur Entstehung von pn-Übergängen mit abgeflachtem Konzentrationsverlauf führen muß. Auch hier soll die Erfindung eine Abhilfe bringen.

Gemäß der Erfindung wird zunächst vorgeschlagen, daß der hochdotierte Bereich der Basiszone wenigstens zum Teil aus polykristallinem Halbleitermaterial, insbesondere aus polykristallinem Silicium besteht.

Außerdem wird zur Verminderung der Abflachung des Konzentrationsverlaufes der Dotierung an den pn-Übergängen des Transistors vorgeschlagen, die Basis unter Anwendung von Niederdruck-Epitaxie (= LP-Epitaxie (= low pressure epitaxy)) oder Molekularstrahl-Epitaxie (= MBE (= molcular beam epitaxy)) oder durch Niederdruck-Epitaxie mit chemischer Abscheidung aus der Gasphase unter Abscheidung von amorphem Halbleitermaterial auf dem aus demselben, aber monokristallinen Halbleitermaterial bestehenden Substrat (= LP CVD )-herzustellen, dabei die Abscheidung bei möglichst niedriger Abscheidungstemperatur vorzunehmen und die erhaltene polykristalline Halbleiterschicht soweit erforderlich durch eine temperierte Laserbehandlung (= laser annealing) in den monokristallinen Zustand überzuführen. Die Dotierung der Basiszone BZ kann dabei während der Abscheidung erfolgen oder anschließend durch Ionenimplantation vorgenommmen werden. Wesentlich ist dabei, daß die Substrattemperatur bei der Abscheidung und Dotierung der Basiszone ausreichend niedrig eingestellt ist, um Autodoping und eine Ausdiffusion aus dem hochdotierten Emittergebiet in die Basis zu vermeiden.

Die Herstellung des polykristallinen Bereiches in der Basiszone läßt sich simultan mit der Herstellung des einkristallinen Teils der Basiszone durch maskierte Epitaxie vornehmen. Dadurch wird die Berührungsfläche zwischen der Basiszone und dem den Emitter enthaltenden Substrat verkleinert, da auf dem unmaskierten Teil der Substratoberfläche das Halbleitermaterial monokristallin, auf dem maskierten Teil, d.h. auf der diesen Teil der Substratoberfläche als Maske abdeckenden $SiO_2$-Schicht, das anfallende Halbleitermaterial hingegen polykristallin aufwächst. Dadurch wird zwar der polykristalline Teil der Basiszone durch den Zusammenhang mit derem einkristallinen Teil ein integrierter Teil des Transistors. Da jedoch keine unmittelbare Verbindung zwischen dem polykristallinen Teil der Basiszone und dem den Emitter enthaltenden Substrat besteht, ist die Entstehung von gespeicherter Ladung unterhalb des polykristallinen Teils der Basiszone im Substrat nicht mehr möglich.

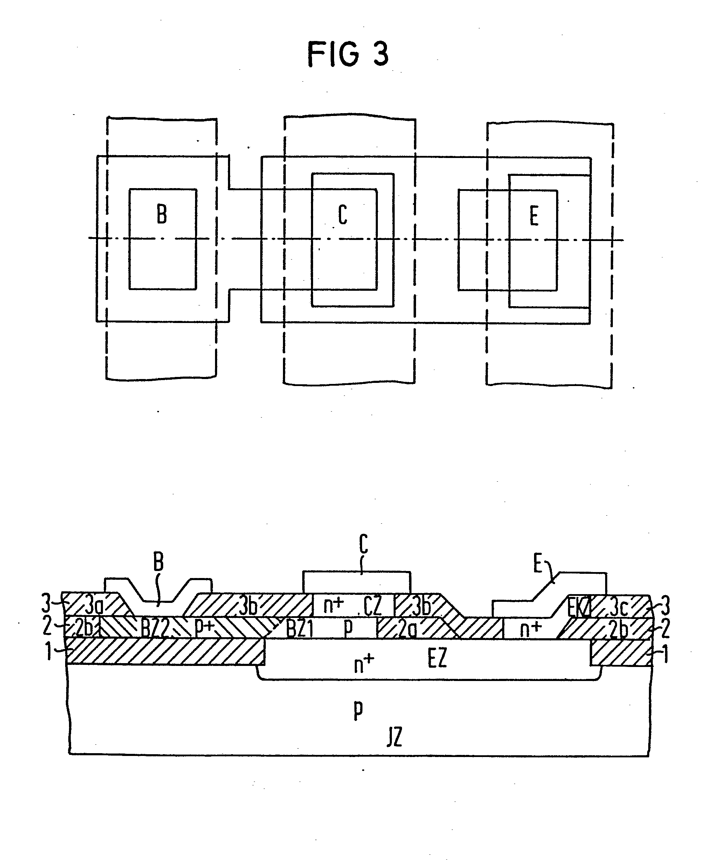

In Fig. 3 ist das Aufbauprinzip eines solchen "Epi-Basis-Transistors" gemäß der Erfindung dargestellt. Der untere Teil der Figur 3 zeigt den Transistor im Schnitt, der obere Teil der Figur 3 im Lay-out. Als Halbleitermaterial wird wohl in den meisten Fällen Silicium verwendet, so daß sich die Beschreibung auf diesen Fall beschränken kann. Die Verwendung anderer Halbleitermaterialien, z.B. von GaAs oder Germanium, ist jedoch möglich. Bei der Verwendung von Silicium als Halbleitermaterial ist aufgrund der oben genannten Gesichtspunkte angestrebt, die Herstellungstemperaturen bei der Herstellung der Basiszone mit ihren beiden Bestandteilen aus monokristallinem Silicium und aus polykristallinem Silicium möglichst unterhalb von $900^\circ C$ zu halten.

Gemäß Fig. 3 wird bei der bevorzugten Ausgestaltung eines erfindungsgemäßen Planartransistors die die Basis BZ bildende Siliciumschicht teils auf der unmittelbaren, also monokristallinen Oberfläche als auch auf einem oxydierten Bereich der Oberfläche des aus monokristallinem Silicium bestehenden Substratplättchens abgeschieden. Damit ist es möglich, die extrinsische Basis bzw. den Basisanschluß auf Oxyd zu legen, was, wie bereits festgestellt, die Minoritätsträgerspeicherung in denjenigen Teilen der Emitterzone EZ unmöglich macht, die sich unterhalb der auf dem Oxyd aufgewachsenen polykristallinen Teile der Basiszone BZ befinden.

Wichtig ist weiter, daß die Dotierung der Emitterzone EZ einen niedrigen Diffusionskoeffizienten hat, so daß man die Emitterzone EZ zweckmäßig mit As oder noch besser mit Sb dotiert. Die sich unterhalb der $n^+$-dotierten Emitterzone EZ befindliche p-dotierte Zone JZ kann durch den nicht umdotierten Teil des ursprünglichen Substrats gegeben sein, an dessen Oberfläche die $n^+$-dotierte Emitterzone EZ nach Art eines "buried layers" erzeugt ist.

Die geometrische Strukturierung der Basiszone BZ erfolgt in bekannter Weise durch selektive Oxydation der die Basiszone BZ bzw. deren Grundlage darstellenden Siliciumschicht 2 unter Verwendung einer Hochdruckoxydation und einer aus $Si_3N_4$-Oxydationsmaske zum Schutz der nicht zu oxydierenden Teile dieser Siliciumschicht 2. Der Hochdruckoxydationsprozeß wird aus den bereits genannten Gründen mit möglichst geringer thermischer Beanspruchung des zu bildenden Transistors vorgenommen. In die entstandene Oxydschicht muß dann noch ein außerhalb der Basiszone BZ zur Emitterzone EZ führendes Kontaktierungsfenster geätzt werden.

Schließlich wird zwecks Herstellung der Kollektorzone CZ die Oberfläche der aus der ursprünglichen Siliciumschicht 2 erhaltenen Basiszone BZ und Oxydschichtteile bei möglichst niedrigen Temperaturen unter Anwendung eines LP CVD Prozesses mit einer polykristallinen $n^+$-dotierten Siliciumschicht 3 abgedeckt, die mindestens sowohl am Ort des zu erzeugenden Kollektors CZ als auch in dem bereits erzeugten Emitter-Kontaktierungsfenster vorhanden sein muß. Dabei ist wichtig, daß die Dotierung in der $n^+$- Polysiliciumschicht 3 höher als die Dotierung in dem monokristallinen Teil BZ1 der p-dotierten Basis BZ eingestellt ist, so daß sich infolge einer nachträglich vorzunehmenden Temperaturbehandlung der pn-Übergang zwischen dem polykristallinen $n^+$-Kollektor CZ und dem monokristallinen intrinsischen Teil BZ1 der Basiszone BZ etwas in den einkristallinen Teil BZ1 der Basiszone hinein verschiebt, da andernfalls die Effizienz des Basis-Kollektor-pn-Übergangs aus bekannten Gründen beeinträchtigt wäre.

Der überschüssige Teil der polykristallinen $n^+$-Siliciumschicht 3 wird wiederum durch selektive Oxydation unter Verwendung einer Siliciumnitrid-Oxydationsmaske in Oxyd übergeführt. In die dabei entstandene Oxydschicht wird dann ein Fenster für die Kontaktierung des polykristallinen Teils BZ2 der Basiszone BZ erzeugt. Schließlich wird der Basiskontakt B, der Emitterkontakt E und auf dem polykristallinen Kollektor CZ der Kollektorkontakt C aufgebracht.

Zu bemerken ist, daß in Alternative zu dem soeben beschriebenen Herstellungsprozeß für die Kollektorzone CZ anstelle der die Grundlage der Kollektorzone CZ bildenden $n^+$-dotierten polykristallinen Siliciumschicht 3 die Schicht eines Metalls abgeschieden werden kann, das mit dem monokristallinen Teil BZ1 der Basiszone BZ einen Schottky-Kontakt derart bildet, daß die Kollektorfunktion durch den Übergang dieser Metallschicht M zu dem einkristallinen Teil BZ1 der Basiszone BZ gewährleistet ist. Dieselbe Metallschicht kann auch zur Kontaktierung der Emitterzone EZ und des polykristallinen Teils
BZ2 der Basiszone BZ verwendet werden.

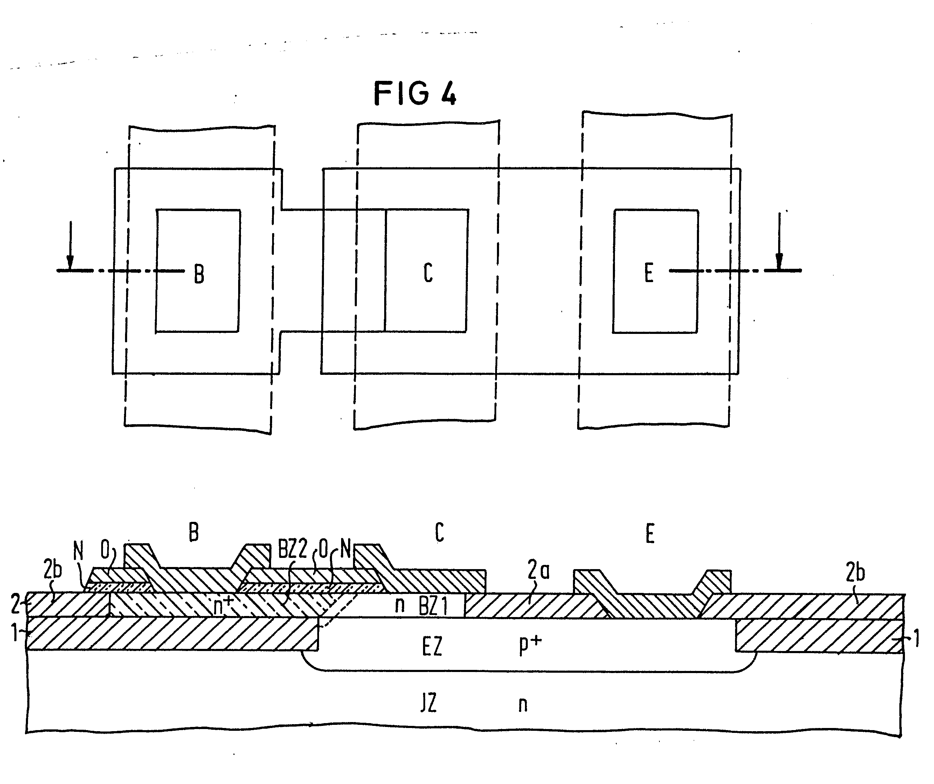

Die soeben skizzierte Möglichkeit wird noch anhand der
Fig. 4 näher beschrieben werden. Im allgemeinen wird
man dann jedoch von einem aus n-dotiertem Silicium bestehenden Substrat ausgehen, in dem dann die Emitterzone
vom $p^+$-Typ hergestellt wird. Die Basiszone BZ besteht
in diesem Fall aus n-dotiertem Silicium, so daß der Transistor eine $p^+$n m-Struktur erhält.

Aufgrund der soeben gegebenen Ausführungen gestaltet sich
ein besonders vorteilhaftes Verfahren zum Herstellen eines Transistors gemäß Fig. 3, wie folgt:

1.) Ausgehend von einem p-dotierten (oder n-dotierten)
Substrat aus monokristallinem Silicium wird auf einer
Flachseite desselben eine aus $SiO_2$ bestehende erste Mas-
kierungs- und Schutzschicht 1 erzeugt. Diese wird dann
mit mindestens einem Diffusionsfenster zur Erzeugung
einer Emitterzone EZ durch Diffusion und/oder Implantation versehen. Als Dotierung für die Emitterzone EZ
empfiehlt sich aus den genannten Gründen insbesondere
Antimon.

Der verbleibende Rest des p-dotierten Substrats ist mit
JZ bezeichnet. Er kann ggf. als Injektor IZ eingesetzt
werden, obwohl die Anwesenheit eines Injektors auch zur
Erzielung einer $I^2$L-Funktion des Transistors bekanntlich
nicht unbedingt erforderlich ist. Falls der p-dotierte
Bereich JZ des Substrats als Injektor arbeiten soll, muß
die Breite der Emitterzone EZ so klein eingestellt werden, daß die von der Injektorzone JZ in die Emitterzone
EZ injizierten Ladungsträger ihren Einfluß bis auf die noch zu erzeugende Basiszone BZ, d.h. deren monokristallinen Teil BZ1 übertragen können. In diesem Falle muß außerdem die die Rolle des Injektors IZ in Fig. 1 übernehmende Zone JZ des Substrats mit einem Anschluß I versehen werden.

Geht man von einem n-dotierten Substrat aus, so muß die dann $p^+$-dotierte Emitterzone EZ ebenfalls mittels eines Dotierungsstoffes mit niedrigem Diffusionskoeffizienten hergestellt werden.

Bei der Herstellung eines Transistors gemäß der Erfindung kann man aber auch von einem homogen dotierten monokristallinen Siliciumplättchen ausgehen, das die Dotierung der Emitterzone EZ im vornherein aufweist. Damit entfallen die zur Herstellung der Emitterzone EZ sonst erforderlichen Dotierungsprozesse. Benötigt wird jedoch die Oxydschicht 1 mit einem zum Substrat durchgehenden Fenster. Falls außerdem eine Injektorzone IZ vorgesehen ist, kann diese z.B. aus der die Grundlage der Basiszone BZ bildenden und dementsprechend teils monokristallin, teils polykristallin abgeschiedenen Siliciumschicht 2 hergestellt sein, wobei der den Injektor IZ bildende Teil dieser Siliciumschicht unmittelbar an der monokristallinen Oberfläche der Emitterzone EZ in der Nachbarschaft des monokristallinen Bereiches BZ1 der Basiszone BZ abgeschieden wird.

Als Beispiel für die Dotierung der Emitterzone EZ bei dem aus Fig. 3 bzw. 4 dargestellten Beispielsfall können folgende Werte genannt werden. Wird beispielsweise die Dotierung des Substrats und damit der Zone JZ auf $10^{16}$ Atome /cm$^3$ eingestellt, dann läßt sich ohne weiteres für die Emitterzone EZ eine Antimondotierung von $10^{18} - 10^{19}$ Atomen/cm$^3$ einstellen. Die Erzeugung der die Dotierungsmaske für den Emitter EZ bildenden und als

0039015

Schutzschicht zum Teil auf der Substratoberfläche verbleibenden und als Träger für den polykristallinen Teil BZ2 der Basiszone BZ dienenden $SiO_2$-Schicht 1 erfolgt zweckmäßig ebenfalls bei möglichst niedriger Temperatur, z.B. durch Verwendung einer Hochdruck-Oxydation (HP-Oxydation der Substratoberfläche.

2.) Nach Erzeugung der Emitterzone EZ wird deren monokristalline Oberfläche, falls diese aufgrund des vorangegangenen Dotierungsprozesses sich mit einer Oxydhaut überzogen haben sollte, wenigstens am Ort des einkristallinen Teiles BZ1 der zu erzeugenden Basiszone BZ sowie am Ort des zu erzeugenden Kontaktes für die Emitterzone EZ freigelegt. Dies kann bekanntlich durch kurzzeitiges Überätzen geschehen, so daß die Dotierungsmaske 1 als solche praktisch erhalten bleibt und ihre oben angegebenen Funktionen ausüben kann.

Die erhaltene Anordnung wird nun an der mit der Emitterzone EZ versehenen Oberflächenseite mit einer durchgehenden Schicht 2 aus p-dotiertem Silicium bei möglichst niedriger Temperatur unter solchen Bedingungen bedeckt, daß diese Schicht 2 auf den freiliegenden Teilen der Emitterzone EZ monokristallin aufwächst, während die auf der Oxydschicht 1 abgeschiedenen Teile dieser Schicht 2 polykristallin entarten.

3.) Zur weiteren Bearbeitung der p-dotierten Siliciumschicht 2 (die im Falle einer $p^+$-dotierten Emitterzone EZ durch eine n-dotierte Siliciumschicht 2 zu ersetzen ist) wird diese mit einer , z.B. durch CVD-Verfahren aufgebrachten maskierenden Schicht aus Siliciumnitrid abgedeckt. Da in Fig. 3 der fertige Zustand des Transistors nur dargestellt ist, ist die Siliciumnitridschicht in Fig. 3 und auch in Fig. 4 nicht dargestellt. Diese Nitridschicht verbleibt an der Oberfläche der gemäß 2.) erzeugten beiden Teile BZ1 und BZ2 der Basiszone BZ zunächst erhalten, während sie im übrigen von der Oberfläche der Siliciumschicht 2 durch Photolack-Ätztechnik in bekannter Weise (z.B. unter Verwendung von heißer Phosphorsäure als Ätzmittel oder durch Plasma-Ätzung) wieder entfernt wird. Dadurch wird insbesondere ein mit 2a bezeichneter Teil des monokristallinen und außerhalb der Basiszone BZ auf der Emitterzone aufgewachsenen Teils der Siliciumschicht 2 sowie der auf der beabsichtigten Kontaktierungsstelle der Emitterzone EZ aufgewachsene Teil der p-dotierten Siliciumschicht 2 von der Nitridschicht befreit. Außerdem werden von den auf der Oxydmaskierung 1 aufgewachsenen polykristallinen Teile dieser Siliciumschicht 2 die außerhalb der Basiszone BZ liegenden Schichtteile ebenfalls freigelegt.

4.) Die nun freiliegenden Stellen der p-dotierten Siliciumschicht 2 werden nun, vorzugsweise unter Verwendung eines Hochdruck-Oxydationsprozesses, restlos in $SiO_2$ umgewandelt. Dadurch entsteht eine zusammenhängende und aus den Teilen 2a und 2b sowie einem über der Kontaktstelle der Emitterzone EZ liegende und die Basiszone lateral rings umgebende $SiO_2$-Schicht.

5.) Dann wird in einem zweiten, die Siliciumnitridschicht betreffenden Abtragungsvorgang die Oberfläche des polykristallinen Teiles BZ2 der Basiszone BZ (ebenfalls unter Anwendung einer Photolack-Ätztechnik) freigelegt. Unmittelbar danach wird die Dotierung in diesem Teil BZ2 der Basiszone BZ verstärkt, während die Dotierung im monokristallinen Teil der BZ1 der Basiszone BZ (wenigstens im Bereich zwischen dem Emitter EZ und der für die Kollektorzone CZ beabsichtigten Stelle der Basiszone BZ)unverändert bleibt. Der den monokristallinen Teil BZ1 der Basiszone noch abdeckende Rest der Nitridmaskierung dient dabei als Dotierungsmaske. Die Basiszone BZ besteht somit aus einem p-dotierten mono-

0039015

kristallinen Teils BZ1, der die eigentliche Basis darstellt, sowie aus einem $p^+$-dotierten polykristallinen, insbesondere der Kontaktierung dienenden Teil BZ2.

6.) Zunächst erfolgt nunmehr die Entfernung des noch vorhandenen Restes der Siliciumnitridschicht und damit die Freilegung der für den Kollektor vorgesehenen Stelle von der Oberfläche der Basiszone BZ. Außerdem muß die Kontaktierungsstelle für die Emitterzone EZ von dem sie nun bedeckenden Teil der durch Umwandlung der p-dotierten Siliciumschicht 2 an der Oberfläche der Emitterzone EZ außerhalb des Bereiches der Basiszone BZ entstandenen Oxydschicht befreit werden. Die Siliciumnitridschicht kann z.B. durch Behandeln mit heißer Phosphorsäure abgetragen werden. Da dieses Ätzmittel weder das Silicium der Basiszone BZ noch das den übrigen Teil der Oberfläche der erhaltenen Anordnung bedeckende $SiO_2$ angreift, wird für diesen Ätzvorgang keine Ätzmaske benötigt. Die Kontaktierungsstelle an der Oberfläche der Emitterzone EZ kann unter Verwendung von verdünnter Flußsäure und einer Photolack-Ätzmaske von dem sie bedeckenden Oxyd befreit werden.

7.) Im Anschluß an die unter 6.) beschriebenen Prozesse erfolgt die Herstellung des Kollektors. Wie bereits angedeutet bestehen hierzu zwei Möglichkeiten, von denen die eine aus Fig. 3, die andere aus Fig. 4 ersichtlich ist.

a) Bei dem aus Fig. 3 ersichtlichen Verfahren zur Herstellung einer Kollektorzone CZ wird eine $n^+$-dotierte Siliciumschicht 3 wenigstens an der Oberfläche des monokristallinen Teiles BZ1 der Basiszone BZ sowie an der Oberfläche der Emitterzone EZ an der gemäß 6.) freigelegten Kontaktierungsstelle zur Abscheidung gebracht.

Wählt man dabei die Abscheidungsbedingungen in bekannter Weise so, daß auf den aus monokristallinem Silicium bestehenden Abscheidungsstellen das aus der Gasphase anfallende Silicium einkristallin wird, so wird die $n^+$-dotierte Siliciumschicht sowohl an der Oberfläche des polykristallinen Teils BZ2 der Basiszone sowie auf der die
Basiszone BZ und die Emitterzone außerhalb der Basiszone
und der Emitterkontaktierungsstelle bedeckenden Oxydschicht
dennoch polykristallin. Arbeitet man mit dieser Variante
bei der Herstellung der Kollektorzone CZ, sowie der Emitter-Kontaktierungszone EKZ, so wird man auch hier möglichst niedrige Abscheidungstemperaturen zwecks Beibehaltung steiler pn-Übergänge anwenden, wie dies bereits bei
der Abscheidung der die Grundlage der Basiszone BZ bildenden p-dotierten Siliciumschicht 2 der Fall war. Eine
Möglichkeit hierzu bildet der bereits erwähnte Prozeß
der LP-Epitaxie, bei dem als Reaktionsgas unter niedrigem
Druck gehaltenes Monosilan im Gemisch mit einer entsprechend hohen Konzentration an Phosphorwasserstoff verwendet wird. Die Abscheidungstemperatur beträgt dann etwa
800 - 900°C.

Im Interesse noch niedrigerer Abscheidungstemperaturen
kann man aber auch die $n^+$-dotierte Siliciumschicht bei
etwa 600°C aus dem genannten Reaktionsgas noch abscheiden,
so daß die Siliciumschicht 3 durchwegs polykristallin
wird. Mit einer bei erhöhter Temperatur vorzunehmenden
Behandlung mit einem Laserstrahl (dem sog. Laser annealing process) läßt sich das auf monokristalliner Siliciumunterlage polykristallin aufgewachsene Silicium in den
monokristallinen Zustand überführen.

Ersichtlich ist eine solche Umwandlung höchstens für den
Bereich der eigentlichen Kollektorzone CZ angebracht, da
für die Emitter-Kontaktierungszone EKZ eine polykristalline Struktur auf jeden Fall entbehrlich ist. Aber auch
für die Kollektorzone CZ kann von einer solchen Umwandlung abgesehen werden, wenn man in bereits angedeuteter Weise dafür sorgt, daß sich nach Erzeugung der endgültigen Form der Kollektorzone CZ sich der pn-Übergang zwischen der monokristallinen Basiszone und der polykristallinen Kollektorzone infolge einer Wärmebehandlung in das Gebiet der monokristallinen Basis BZ1 hinein verlagert.

Unmittelbar nach der $n^+$-dotierten Siliciumschicht 3 wird auf dieser erneut eine Siliciumnitrid-Oxydationsmaske derart aufgebracht, daß von ihr die Oberfläche der beabsichtigten Kollektorzone CZ und die Oberfläche des mit der Emitterzone EZ in Kontakt stehenden Teiles EKZ dieser Siliciumschicht 3 bedeckt ist, während der Rest der Siliciumschicht 3 - wiederum durch einen HP-Oxydationsprozeß - in Siliciumdioxyd umgewandelt wird. Die dabei entstehende $SiO_2$-Schicht grenzt rings an den Kollektor CZ sowie an die Emitterkontaktierungszone EKZ an.

Daraufhin wird in der soeben entstandenen Oxydschicht das für die Kontaktierung der Basiszone BZ erforderliche Kontaktierungsfenster in der auf dem polykristallinen Teil BZ2 aus der Polysiliciumschicht 3 entstandenen Oxydschicht erzeugt, wozu man wiederum eine Photolack-Ätztechnik anwendet. Schließlich wird auch die Nitrid-Oxydationsmaske entfernt und somit auch die Kontaktstelle für die Kollektorzone CZ und die Emitterkontaktierungsschicht EKZ freigelegt. Auf den freigelegten Kontaktstellen wird die Basiselektrode B, die Kollektorelektrode C und die Emitterelektrode E, z.B. unter Verwendung von Al als Kontaktmaterial, in üblicher Weise aufgebracht.

b) Bei dem anhand von Fig. 3 ersichtlichen Herstellungsverfahren wird im Falle, daß die Emitterzone EZ $p^+$-dotiert und demgemäß die Basiszone BZ n-dotiert ist, für den Kollektor eine $p^+$-dotierte polykristalline Siliciumschicht abgeschieden. Im übrigen verläuft der Herstellungsprozeß analog zu dem soeben beschriebenen Verfahren.

Die durch die Oxydation in Oxyd umgewandelten Teile der Siliciumschicht 3 sind in Fig. 3 mit 3a 3b und 3c bezeichnet.

b) Bei dem aus Fig. 4 ersichtlichen Prozeß zur Herstellung eines Planartransistors gemäß der Erfindung wird bei der Herstellung der Basiszone BZ entsprechend dem anhand von Fig. 3 beschriebenen Prozeß vorgegangen. Jedoch wird anstelle der zweiten Siliciumschicht 3 eine die Grundlage des Kollektors und gleichzeitig der Kollektorelektrode C bildende Metallschicht, z.B. durch Aufdampfen, aufgebracht. Diese Metallschicht ist so gewählt, daß sie mit dem sie tragenden monokristallinen Teil der Basiszone BZ einen Schottky-Kontakt-Kollektor C bildet. Ersichtlich wird durch diese Möglichkeit das Herstellungsverfahren sowie die Struktur des erhaltenen Planartransistors gegenüber dem in Fig. 3 dargestellten Fall merklich vereinfacht. Zweckmäßig wählt man für diesen Fall eine Transistorstruktur mit einer n-dotierten Basiszone BZ, da einfacher ist, auf einer solchen Basiszone als auf einer p-dotierten Basiszone einen Schottky-Kollektor zu erzeugen.

Dementsprechend besteht bei dem in Fig. 4 dargestellten Planartransistor das 'Substrat aus n-dotiertem monokristallinem Silicium, von dem nach Herstellung der $p^+$-dotierten Emitterzone EZ unter Verwendung der aus $SiO_2$ bestehenden strukturierten Oxydschicht 1 als Dotierungsmaske der mit JZ bezeichnete n dotierte Teil übrig geblieben ist. Auf der einkristallinen Oberfläche der Emitterzone EZ und der auf der Substratoberfläche verbleibenden Maskierungsschicht 1 wird dann die die Grundlage der Basiszone bildende, nunmehr n-dotierte Siliciumschicht 2 unter denselben Gesichtspunkten wie die p-dotierte Siliciumschicht 2 bei Herstellung des Transistors gem. Fig. 3 abgeschieden und weiter verarbeitet.

Nach der entsprechend den bei Betrachtung der Fig. 3 gebrachten Darlegungen erfolgten Umwandlung der Teile 2a und 2b der n-dotierten Siliciumschicht 2 in Oxyd wird in der hierzu verwendeten Nitrid-Oxydationsmaske N eine der Kontaktierung und lokalen Nachdotierung des polykristallinen Teils BZ2 der Basiszone BZ dienendes Fenster erzeugt und die Nitridschicht N von dem für den Schottky-Kollektor C vorgesehenen Oberflächenteil des monokristallinen Teils BZ1 der Basiszone durch maskierte Ätztechnik entfernt, während der noch vorhandene Rest der Nitrid-Oxydationsmaske N zweckmäßig erhalten bleibt.

Auf die so behandelte Oberfläche der herzustellenden Transistoranordnung wird dann die den Schottky-Kontakt bildende Metallschicht aufgebracht, nachdem die Reste der Nitrid-Maskierung N durch eine bei niedriger Temperatur abgeschiedene $SiO_2$-Schicht O verstärkt wurde.

Schließlich wird die Schottky-Metallschicht durch entsprechende Ätzbehandlung auf den Bereich der Basiselektrode B, der Kollektorelektrode C und der Emitterelektrode E reduziert. Dabei ist zu erwähnen, daß vor dem Aufbringen der Schottky-Metallschicht nicht nur die Kontaktstelle für die Basis an der Oberfläche des polykristallinen Teils der Basiszone sondern auch die Kontaktstelle für die Emitterzone EZ durch lokalisiertes Entfernen der aus der n-dotierten Siliciumschicht 2 an der Emitter-Kontaktierungsstelle entstandenen Oxydschicht freizulegen ist. Außerdem wird vor dem Aufbringen der Schottky-Metallschicht das vorher erzeugte Kontaktierungsfenster für die Basiszone in der Nitridschicht N bzw. Oxydschicht O dazu verwendet, um die n-Dotierung des polykristallinen Teils BZ2 der Basiszone lokalisiert verstärken zu können.

Die Dotierung in den beiden Teilen BZ1 und BZ2 der Basis-

0039015

zone BZ werden in bekannter Weise so aufeinander abgestimmt, daß die Basiselektrode B mit dem polykristallinen Basisteil BZ2 einen sperrfreien Kontakt und die Kollektorelektrode C mit dem monokristallinen Teil BZ1 einen sperrenden Schottky-Kontakt bildet, obwohl beide Elektroden aus demselben Material, z.B. Aluminium, bestehen. Die Emitterelektrode E, die aus demselben Metall wie die Kollektor- und die Basiselektrode besteht, gibt mit dem $p^+$-dotierten Emitter EZ zwangsläufig einen sperrfreien Emitterkontakt.

Die Erfindung ist anhand der Verwendung von Silicium als Halbleitermaterial beschrieben worden. Die Verwendung anderer Halbleitermaterialien ist aber bei Beachtung der für das betreffende andere Halbleitermaterial zu berücksichtigenden Technologien ebenfalls möglich, wobei ersichtlich mit denselben Vorteilen gerechnet werden kann.

4 Figuren
18 Patentansprüche

Patentansprüche

1. Planartransistor, insbesondere für $I^2L$-Strukturen, bei dem an der Oberfläche eines insbesondere aus monokristallinem Silicium bestehenden Halbleiterplättchens wenigstens eine von der Basiszone vom übrigen Teil des Halbleiterplättchens getrennte Kollektorzone vorgesehen ist, bei dem die Basiszone am Ort der Basiselektrode höher als im Bereich zwischen der Kollektorzone und der Emitterzone dotiert ist und bei dem schließlich die Halbleiteroberfläche wenigstens am Ort der pn-Übergänge mit einer anorganischen Isolierschicht, insbesondere aus $SiO_2$, abgedeckt ist, dadurch gekennzeichnet, daß der hochdotierte Bereich der Basiszone wenigstens zum Teil aus polykristallinem Halbleitermaterial, insbesondere aus polykristallinem Silicium, besteht.

2. Planartransistor nach Anspruch 1, dadurch gekennzeichnet, daß sich die hochdotierte Emitterzone (EZ) an einer Oberflächenseite des monokristallinen Halbleiterplättchens befindet, daß dieser Oberflächenteil zum teil mit einer Schicht (1) aus anorganischem Isoliermaterial abgedeckt ist, daß sich dabei der monokristalline Teil (BZ1) der Basiszone (BZ) an der Oberfläche der Emitterzone (EZ) und der polykristalline Teil (BZ2) der Basiszone an der Oberfläche der Schicht (1) aus anorganischem Isoliermaterial befindet und daß schließlich der Kollektor (CZ, C) an der Oberfläche des monokristallinen Teils der Basiszone (BZ) angeordnet ist.

3. Planartransistor nach Anspruch 2, dadurch gekennzeichnet, daß die Emitterzone (EZ) und die Kollektorzone (CZ) $n^+$-dotiert, der monokristalline Teil (BZ1) der Basiszone (BZ) p-dotiert und der polykristalline Teil (BZ2) der Basiszone $p^+$-dotiert ist.

4. Planartransistor nach Anspruch 2, dadurch gekennzeichnet, daß die Emitterzone (EZ) $p^+$-dotiert, der monokristalline Teil (BZ1) der Basiszone (BZ) n-dotiert, der polykristalline Teil (BZ2) der Basiszone (BZ) $n^+$-dotiert und die Kollektorzone (CZ) $p^+$-dotiert ist.

5. Planartransistor nach Anspruch 2, dadurch gekennzeichnet, daß die Emitterzone (EZ) $p^+$-dotiert, der monokristalline Teil (BZ1) der Basiszone (BZ) n-dotiert, der polykristalline Teil (BZ2) der Basiszone (BZ) $p^+$-dotiert und der Kollektor (C) als Schottky-Kontakt ausgebildet ist.

6. Planartransistor nach einem der Ansprüche 1 bis 5, dadurch gekennzeichnet, daß die Emitterzone (EZ) durch lokalisiertes Umdotieren eines Teiles der Oberfläche eines den entgegengesetzten Leitungstyp aufweisenden und schwächer als die Emitterzone dotierten monokristallinen Halbleiterplättchens unter Verwendung der anorganischen Isolierschicht (1) als Dotierungsmaske hergestellt ist.

7. Planartransistor nach einem der Ansprüche 1 -4 bzw. 6, dadurch gekennzeichnet, daß die Kollektorzone (CZ) mit Ausnahme des an den Basis-Kollektor-pn-Übergang grenzenden Teiles aus polykristallinem Halbleitermaterial besteht.

8. Planartransistor nach einem der Ansprüche 1 bis 8, dadurch gekennzeichnet, daß eine an die Emitterzone (EZ) grenzende und durch sie von der Basiszone getrennte monokristalline Halbleiterzone vom Leitungstyp der Basiszone (BZ) als Injektor (IZ) vorgesehen ist.

9. Verfahren zum Herstellen eines Transistors nach einem der Ansprüche 1 bis 9, dadurch gekennzeichnet, daß an der Oberfläche eines aus monokristallinem Silicium bestehenden Halbleiterplättchens vom einen Leitungstyp an einer Oberflächenseite eines aus $SiO_2$ bestehende Dotierungsmaske (1) erzeugt und durch lokales Umdotieren des Siliciumplättchens an einem durch die Dotierungsmaske (1) nicht bedeckten Teil seiner Oberfläche die Emitterzone des Transistors hergestellt wird, daß dann unter Anwesenheit der Dotierungsmaske (1) an der monokristallinen Oberfläche der Emitterzone sowie auf einem an die Emitterzone (EZ) angrenzenden Teil der Dotierungsmaske eine den entgegengesetzten Leitungstyp zu dem der Emitterzone (EZ) aufweisende Siliciumschicht (2) epitaktisch derart abgeschieden wird, daß der auf die Emitterzone (EZ) aufgewachsene Teil (BZ1) monokristallin, der auf die Dotierungsmaske (1) aufgewachsene Teil (BZ2) hingegen polykristallin ist, daß dann auf dem den monokristallinen Teil (BZ1) der Basiszone (BZ) der Kollektor (C, CZ) des Transistors aufgebracht und auf dem polykristallinen Teil (BZ2) der Siliciumschicht (2) - nach Verstärkung der dortigen Dotierung - der Basiskontakt (B) des Transistors aufgebracht wird.

10. Verfahren nach Anspruch 10, dadurch gekennzeichnet, daß im Anschluß an die Abscheidung der die Grundlage der Basiszone (BZ) bildenden Siliciumschicht (2) diese Schicht an den für den monokristallinen Teil (BZ1) und für den polykristallinen Teil (BZ2) der Basiszone (BZ) vorgesehenen Stellen mit einer Oxydationsmaske (N) abgedeckt und dann außerhalb der abgedeckten Stellen durch Oxydation in Siliciumdioxyd (2a, 2b) übergeführt wird.

11. Verfahren nach Anspruch 11, dadurch gekennzeichnet, daß abseits von der Basiszone (BZ) in dem sich auf der Emitterzone (EZ) infolge der Oxydation entstandenen $SiO_2$ ein zur Oberfläche der Emitterzone (EZ) führendes Kontaktierungsfenster erzeugt und zuvor nach wenigstens partieller Freilegung der Oberfläche des aus polykristallinem Silicium bestehenden Teiles (BZ2) des die Basiszone (BZ) bildenden Teils der dotierten Siliciumschicht (2) die Dotierung in diesem polykristallinen Teil (BZ2) der Basiszone (BZ) wenigstens am Ort des Basiskontaktes (B) verstärkt wird.

12. Verfahren nach Anspruch 12, dadurch gekennzeichnet, daß nach Entfernung des Restes der Oxydations-Siliciumnitridmaske (N) von der Oberfläche des den monokristallinen Teil (BZ1) der Basiszone (BZ) bildenden Teiles der dotierten Siliciumschicht (2) diese sowohl in ihrem monokristallinen Teil (BZ1) als auch in ihrem polykristallinen Teil (BZ2) als auch die in $SiO_2$ umgewandelten Teile (2a, 2b) dieser Siliciumschicht (2) und die von diesem $SiO_2$ freigelegte Kontaktierungsstelle an der Oberfläche der Emitterzone (EZ) mit einer Schicht (3) aus hochdotiertem Silicium vom Leitungstyp der Emitterzone (EZ) abgedeckt wird, welche die Grundlage der Kollektorzone (CZ) bildet und mit Ausnahme eines an der Oberfläche des monokristallinen Teiles (BZ1) der Basiszone (BZ) verbleibenden Teiles (CZ) sowie eines vom Kollektor (CZ) getrennten, an der freigelegten Emitteroberfläche (EZ) verbleibenden Teiles (EKZ) wieder entfernt wird.

13. Verfahren nach Anspruch 13, dadurch gekennzeichnet, daß an der Oberfläche des mit verstärkter Dotierung versehenen polykristallinen Teiles (BZ2) der Basiszone (BZ) als auch an der Oberfläche der Kollektorzone (CZ) als auch zur Emitteroberfläche (EZ) je ein sperrfreier Anschlußkontakt (B, C, E, EKZ) erzeugt wird.

14. Verfahren nach Anspruch 13, dadurch gekennzeichnet, daß die die Grundlage des Kollektors (CZ) bildende Siliciumschicht (3) in polykristallinem Zustand an der Oberfläche des monokristallinen Teils (BZ1) der Basiszone (BZ) in polykristallinem Zustand abgeschieden wird und die erhaltene Anordnung nachträglich zwecks Verschiebung des Basis-Kollektor-pn-Übergangs in den monokristallinen Teil der Basis hinein getempert wird.

15. Verfahren nach Anspruch 12, <u>dadurch gekennzeichnet</u>, daß an der Oberfläche des monokristallinen Teiles der Basiszone (BZ) ein den Kollektor (C) darstellender Schottky-Kontakt erzeugt wird.

16. Verfahren nach Anspruch 16, <u>dadurch gekennzeichnet</u>, daß als Material für den Emitteranschluß (E) und den Basisanschluß (B) das den Schottky-Kontakt des Kollektors (C) bildende Metall verwendet und zusammen mit dem Schottky-Kollektor auf der betreffenden Kontaktierungsstelle aufgebracht wird.

17. Verfahren nach einem der Ansprüche 10 - 17, <u>dadurch gekennzeichnet</u>, daß für die Dotierung der Emitterzone (EZ) ein Dotierungsmaterial mit niedrigem Diffusionskoeffizienten, z.B. Sb oder B, verwendet wird.

18. Verfahren nach einem der Ansprüche 10 - 18, <u>dadurch gekennzeichnet</u>, die bei der Herstellung zur Anwendung kommenden Dotierungsprozesse, Abscheidungsprozesse und Oxydationsprozesse unter solchen Bedingungen durchgeführt werden, daß am Emitter-Basis-pn-Übergang ein steiler Dotierungsgradient entsteht und daß die Steilheit dieses Dotierungsgradienten erhalten bleibt.

FIG 1

FIG 2

# FIG 3

0039015

FIG 4